(19) **Europäisches Patentamt**
**European Patent Office**
**Office européen des brevets**

(11) **EP 2 031 101 A2**

(12) **EUROPÄISCHE PATENTANMELDUNG**

(43) Veröffentlichungstag:
**04.03.2009 Patentblatt 2009/10**

(51) Int Cl.:
***C30B 29/06*** *(2006.01)*     ***C30B 33/08*** *(2006.01)*

(21) Anmeldenummer: **08015054.3**

(22) Anmeldetag: **26.08.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **27.08.2007 DE 102007040390**
          **27.08.2007 DE 102007040385**

(71) Anmelder: **Schott AG**
**55122 Mainz (DE)**

(72) Erfinder:
• **Menzel, Andreas**
 **07745 Jena (DE)**
• **Sigmund, Jochen, Dr.**
 **07743 Jena (DE)**
• **Fugger, Chistine, Dr.**
 **07743 Jena (DE)**

(74) Vertreter: **Fuchs**
**Patentanwälte**
**Naupliastrasse 110**
**81545 München (DE)**

(54) **Verfahren zur Herstellung von Siliziumwafern**

(57) Es wird ein Verfahren zur Herstellung von Siliziumwafern durch Zerteilen von Siliziumblöcken beschrieben, bei dem wenigstens an einer Seitenfläche des Siliziumblockes ein Materialabtrag mittels Ätzen erfolgt. Dabei beträgt der mittlere Materialabtrag 3 bis 160 $\mu$m und erfolgt isotrop mit einer konstanten mittleren Abtragsgeschwiridigkeit von 1 bis 20 $\mu$m pro Minute über die gesamte Seitenfläche hinweg. Die Ätzbehandlung erfolgt üblicherweise mittels einer starken oxidierenden Säure oder einer Mischung davon. Mit dem Verfahren sind rissfreie Siliziumblöcke sowie mikrorissfreie Wafer mit verbesserter Bruchfestigkeit erhältlich.

EP 2 031 101 A2

**Beschreibung**

Die vorliegende Erfindung betrifft ein Verfahren zur Herstellung von Siliziumwafern durch Zerteilen eines Siliziumblocks bzw. -bricks, wobei wenigstens eine Seitenfläche des Siliziumblocks vor dem Zerteilen geätzt wird. Die Erfindung betrifft auch die mit dem Verfahren hergestellten Siliziumblöcke und Wafer.

Siliziumwafer sind dünne Scheiben aus kristallinem Silizium und bilden die Basis für die Herstellung von Solarzellen und damit auch für die Herstellung von Solarmodulen. Entsprechend der zunehmenden Verbreitung von Solarzellen und dergleichen nimmt die Nachfrage nach Siliziumwafern von Jahr zu Jahr zu.

Die Produktion der Siliziumwafer beginnt mit der Herstellung von Blöcken aus kristallinen Siliziumingots, und zwar sowohl aus mono- als auch aus polykristallinem Material, die in runder Form oder auch als Quader gezüchtet werden. In einem weiteren Schritt werden dann diese kristallinen Ingots zu weiteren quaderförmigen Blöcken zerteilt bzw. gesägt. Diese Blöcke werden auch als Säulen oder Bricks bezeichnet und weisen üblicherweise bei monokristallinem Silizium einen annähernd quadratischen bzw. bei multikristallinem Silizium einen exakt quadratischen Querschnitt auf.

Aus diesen Blöcken werden dann in einem weiteren Schritt die einzelnen Waferscheiben herausgesägt, und zwar üblicherweise quer zu ihrer Längsrichtung, so dass die durch Sägen entstandenen Seitenflächen der säulenförmigen Blöcke bzw. Bricks die Kantenflächen der so erzeugten Wafer bilden. Es hat sich gezeigt, dass bei der Herstellung der Bricks an den durch Sägen entstandenen Seitenflächen feinste, oft mikroskopisch kleine Risse entstehen, die mit einer mehr oder weniger großen Eindringtiefe in das Volumen des Blockes bzw. damit in die Kanten des späteren Wafers vordringen.

Silizium ist ein äußerst sprödes Material. Anders als bei Metallen kann sich ein Riss im Material daher bei Belastung rasch ausbreiten. Eine normale Beanspruchung, beispielsweise beim Handling in der Zellenproduktion, kann bei Vorhandensein von Rissen, insbesondere in der Kante des Wafers, schnell zum Bruch des Wafers führen.

Da die Herstellung der Siliziumwafer einen Kostenanteil von ca. 55 % an der Herstellung der Solarzellen ausmacht, führt ein hoher Anteil an zerbrochenen Siliziumwafern, d. h. eine hohe Bruchrate, zu einem deutlichen Kostenanstieg in der Herstellung der Solarzellen.

Darüber hinaus gebietet es die weltweite Verknappung von Silizium, in der Zukunft extrem dünne Siliziumwafer herzustellen. Sofern Risse in diesen dünnen Siliziumwafern vorliegen, neigen diese dünnen Wafer verstärkt zu einem Bruch. Risse in den Kanten der Wafer sind besonders kritisch.

Zur Vermeidung der zuvor beschriebenen Probleme wird deshalb in der US 2002 036182 AA vorgeschlagen, die Rauhigkeit der Oberflächen solcher Silikonblöcke vor der Herstellung der Silikonwafer zu verringern, was gemäß der JP 3,648,239 mittels einem mechanischen Polieren erfolgen soll. Dabei wird unter Polieren ausdrücklich die Behandlung mit einem losen Korn verstanden. Schließlich wird in der US-A 5,484,326 ein Zerteilungsverfahren für einen Halbleiter beschrieben, bei dem die Oberflächen eines Siliziumblocks zuvor geschliffen werden.

Es hat sich jedoch gezeigt, dass mit diesen Verfahren zwar eine Verbesserung der Bruchhäufigkeit der geschnittenen Siliziumwafer erreicht werden kann, dies jedoch insbesonders für sehr dünne Wafer nicht ausreichend ist.

Die US 6,099,748 beschreibt, dass sich die Oberflächen von Silikonwafern mittels alkalischen Lösungen Anätzen lassen. Dabei wird davon ausgegangen, dass die Ätzgeschwindigkeit bezüglich der <100>-Oberfläche etwa das 60- bis 100-fache von derjenigen der <111>-Kristalloberfläche beträgt. Hiervon ausgehend wird vorgeschlagen, die Waferoberflächen mittels einer wässerigen Alkalilösung zu ätzen, welche einen Alkaligehalt von 50,6 bis 55,0 Gew.-% aufweist. Dabei soll das Ätzen bei einer Temperatur von 65 bis 85°C durchgeführt werden, wobei von der Waferoberfläche 15 bis 40 $\mu$m der gesamten Dicke an beiden Waferseiten abgeätzt werden.

Eine Aufgabe der vorliegenden Erfindung war es daher, die Bruchrate bei der Herstellung von Siliziumwafern zu verbessern und deutlich zu reduzieren. Insbesondere soll die Bruchrate bei der Produktion von möglichst dünnen Wafern mit einer Dicke von < 230 $\mu$m reduziert werden.

Diese Aufgabe wird durch ein Verfahren zur Herstellung von Siliziumwafern gemäß Anspruch 1 gelöst.

Diese Aufgabe wird durch ein Verfahren zur Herstellung von Siliziumwafern gelöst, die eine Oberfläche und Seitenkanten aufweisen und die durch Zerteilen eines insbesonders quaderförmigen Seitenflächen aufweisenden Siliziumblocks bzw.

- bricks erhalten werden, der zuvor gemäß Anspruch 1 einer Ätzbehandlung unterzogen wurde.

Erfindungsgemäß wurde nämlich gefunden, dass sich Mikrorisse und Defekte, die an der Oberfläche der Siliziumblöcke bzw. -säulen, insbesonders durch vorhergehendes Absägen von Material beim Quadrieren der Ingots entstanden sind, durch ein isotropes Ätzen soweit aufweiten lassen, dass diese an der späteren Außenkante oder Kantenfläche der Wafer liegenden Defekte oder Strukturen auch in der Beanspruchung sich nicht mehr spontan verlängern bzw. in das Materialinnere fortschreiten und so zum Bruch des Wafers führen.

Dabei wurde auch gefunden, dass nicht die Rauhigkeit des Siliziumblocks die Hauptursache des Waferbruchs ist. Vielmehr sind auch Subsurface-Defekte, wie beispielsweise Mikrorisse in den oberflächennahen Schichten, für den Bruch ausgehend von der Waferkante verantwortlich. Insbesondere sind die Spitze und der Verlauf der Mikrorisse entscheidend für das Bruchverhalten der Siliziumwafer. Durch das erfindungsgemäße Verfahren wird die Rissspitze verbreitert bzw. abgelenkt.

Dabei werden die Seitenflächen des Siliziumbricks bzw. der Siliziumsäule oder -blocks im Wesentlichen derart isotrop geätzt, dass mehr als 90% aller an der gesägten Oberfläche mittels Lichtmikroskop pro Flächeneinheit nach dem Ätzen verschwunden sind. Dabei ist es zulässig, zur besseren Zählbarkeit die den Ausgangszustand charakterisierenden Risse, die Ausgangsoberfläche um den Betrag der Profiltiefe $P_x$ nach DIN ISO 4287 abzupolieren. Experimente haben gezeigt, dass die weniger als 10% nach dem Ätzen noch feststellbaren Risse so weit verbreitert sind und vor allem eine so abgerundete Rissspitze aufweisen, dass von den verbleibenden Rissen keine Bruchgefahr für den gesägten Wafer mehr ausgeht. Erfindungsgemäß wurde nämlich gefunden, dass die Risse bzw. Mikrorisse dann zum Bruch bei den daraus hergestellten Wafern führen, wenn das Ende des Risstals bzw. des tiefen Peaks besonders spitz verläuft. D. h. umso breiter der Riss oder die Kavität ist, umso weniger besteht die Gefahr, dass sich diese spontan zu einem Bruch fortpflanzen. Dabei kommt es zwar auf die Tiefe des jeweiligen Risses bzw. des Materialeinschnittes des durch den Riss gebildeten Tales an aber insbesondere lediglich auf seinen mehr oder weniger spitzen Verlauf. Gemäß der Erfindung wird daher derart isotrop geätzt, dass sich der jeweilige Riss erweitert bzw. verbreitert und die Spitze des Risses sich verrundet, wodurch ein Fortschreiten eines derartigen Risses drastisch verringert wird.

Die Seitenflächen des Siliziumblocks entsprechen nach dem Wafersägen den Kanten bzw. der Umfangsfläche des daraus geschnittenen bzw. gesägten Siliziumwafers.

Im Sinne der vorliegenden Erfindung wird unter Ätzen das chemische Abtragen bzw. Auflösen von Material, d. h. von Siliziummaterial, verstanden, und zwar auch in den Vertiefungen bzw. Rissen, welche an oder auch unter der Oberfläche vorliegen. Unter dem Begriff "isotropes Ätzen" wird demgemäß erfindungsgemäß ein chemischer Abtrag verstanden, der entlang jeder Kristallrichtung mit mehr oder weniger gleichmäßiger Geschwindigkeit erfolgt, d. h. dass die Ätzgeschwindigkeit entlang der <100>-Ebene, der <111>-Ebene sowie der <110>-Ebene im Wesentlichen gleichförmig verläuft. Dabei wird erfindungsgemäß ein Ätzen als isotrop bezeichnet, dessen Ätzgeschwindigkeit in verschiedenen Kristallrichtungen im Wesentlichen gleichförmig ist. Dabei werden nur die Ätzgeschwindigkeitsunterschiede zwischen Körnern unterschiedlicher Orientierungen betrachtet, wobei sich die Ätzgeschwindigkeiten vorzugsweise nicht mehr als das 1,3-fache, bevorzugt 1,1-fache und besonders bevorzugt 1,05-fache voneinander unterscheiden. Unterschiede im Ätzverhalten an Korngrenzen oder Versetzungen sind in diese Definition des isotropen Ätzverhaltens nicht eingeschlossen.

Darüber hinaus wird erfindungsgemäß derart geätzt, dass der Abtrag über die jeweilige Oberfläche des Siliziumbricks hinweg mehr oder weniger gleichmäßig erfolgt. Ein im Wesentlichen gleichmäßiger Abtrag bedeutet im Rahmen der vorliegenden Erfindung, dass die Höhe des Abtrags über die gesamte jeweilige Seitenfläche maximal um 10 μm schwankt, wobei maximale Schwankungen von 8, insbesonders von 5 bzw. 4 μm besonders bevorzugt sind.

Im erfindungsgemäßen Verfahren erfolgt das Ätzen üblicherweise mit einer mittleren Abtragsgeschwindigkeit von 1 bis 20 μm pro Minute, insbesondere von 3 bis 15 μm pro Minute.

Auf diese Weise wird vermieden, dass sich Risse am gesägten Wafer von der Waferkante ausgehend in Richtung des Inneren des Wafers fortsetzen. Somit kann auch die Bruchrate der Siliziumwafer deutlich gesenkt werden.

Vorzugsweise wird der Siliziumblock für eine Dauer von mindestens 30 Sekunden, vorzugsweise mindestens 45 Sekunden, insbesondere mindestens 60 Sekunden geätzt. Eine typische maximale Behandlungsdauer beträgt 300 Sekunden, wobei maximal 250 Sekunden, insbesondere maximal 200 bzw. 150 Sekunden bevorzugt sind. Dabei hängt die Dauer auch von der Größe der Oberfläche, der Temperatur und der Ätzrezeptoren ab und wird jeweils so gewählt, dass ein isotropes Ätzen bzw. ein Ätzen im Grenzbereich isotrop / anisotrop möglich ist. Die jeweiligen Bedingungen für ein Ätzen im isotropen Bereich bzw. Grenzbereich isotrop / anisotrop sind vom Fachmann anhand weniger Versuche zu ermitteln.

Die im Mittel abzutragende Schichtdicke ist vom Ausgangszustand der Mantelfächen des Bricks vor Ätzbeginn abhängig. Ist die Mantelfläche des Bricks roh gesägt, d. h. Ergebnis eines Drahtsägeprozesses (Squaren), dann ist ein mittlerer Abtrag von 25 bis 100 μm erforderlich. Ist die Mantelfläche des Bricks nach dem Squaren noch grob geschliffen worden (Dimensionsschleifen), dann sind im Mittel 8 bis 50 μm abzuätzen. Ist die Mantelfläche des Bricks zusätzlich vorher feingeschliffen worden, sind im Mittel nur 5 bis 25 μm abzuätzen. Auch wenn die Mantelfläche des Bricks jedoch vollständig im duktilen Bereich feingeschliffen worden ist mit dem Ergebnis, dass die Oberfläche dem Kriterium für polierte Oberflächen entspricht, d. h. dass die maximale Rautiefe $R_x$ mit λ/2 bis λ/60 unterhalb der Lichtwellenlänge liegt, kann ein Ätzen noch zu einem, wenn auch geringer ausgeprägten Erfolg führen. Da auch eine solche Oberfläche infolge beim Feinschleifen ausbrechender Schleifkörner nicht 100%-ig frei von Subsurface-Defekten ist, kann durch sehr kurzzeitiges Ätzen von 20 - 30 Sekunden immer noch eine geringfügige Verbesserung der Bruchgefahr des Wafers erreicht werden.

Vorzugsweise wird der Siliziumblock bei einer möglichst geringen Temperatur geätzt, wobei jedoch aus ökonomischen Gründen sich Temperaturen von mindestens 18°C, insbesonders mindestens 20°C als zweckmäßig erwiesen haben. Weitere zweckmäßige Maximaltemperaturen betragen höchstens 25, insbesonders höchstens 23°C, wobei Höchsttemperaturen von 22°C besonders bevorzugt sind.

Erfindungsgemäß wurde auch gefunden, dass ein isotropes Verhalten dadurch gesteigert werden kann, dass die jeweils gewählte Temperatur während der Ätzdauer sowie an den unterschiedlichen Ätzstellen, d. h. an verschiedenen Stellen des Siliziumbricks maximal +/- 2°C schwankt, wobei maximale Unterschiede von +/- 1°C, insbesonders +/- 0,5°C bevorzugt sind. Ganz bevorzugt sind Schwankungen, die nicht größer als +/- 0,2 °C bzw. +/- 0,1 °C betragen. Eine große Flüssigkeitsmenge und hohe Kühlleistung erleichtert das Einhalten dieser Bedingungen. Das Einhalten einer möglichst konstanten Temperatur fördert dabei das isotrope Verhalten beim Ätzen.

Bei dem verwendeten Ätzverfahren handelt es sich um ein Nass-Ätzverfahren, das vorzugsweise in einem sauren Medium durchgeführt wird. Bevorzugte Säuren sind starke oxidierende Säuren wie Schwefelsäure, Salpetersäure und/oder Flusssäure, sowie die entsprechenden Peroxosäuren hiervon.

Vorzugsweise wird der Siliziumblock mit einer Lösung von 50-70%-iger Salpetersäure und 40-60%-iger Flusssäure in einem Verhältnis im Bereich von 10:1 bis 1:1, bevorzugt im Bereich von 8:1 bis 4:1 geätzt, wobei die vorgenannten Verhältnisse Volumenverhältnisse sind.

Dieser Mischung werden üblicherweise noch weitere Additive zugesetzt, die das Ziel haben, die Reaktion zu moderieren. Bevorzugt wird der Lösung eine Flüssigkeit, wie z. B. Wasser, Essigsäure, Wasserstoffperoxid oder ein die Oberflächenenergie senkendes Tensid (Netzmittel), zugesetzt.

Es hat sich gezeigt, dass es zweckmäßig ist, die beim Ätzen verbrauchten Säuren nachzudosieren. Dabei kann die Nachdosierung sowohl kontinuierlich als auch chargenweise erfolgen. Das jeweilige Zudosieren kann nach einer bestimmten Verbrauchsdauer aufgrund von bereits zuvor ermittelten Erfahrungswerten erfolgen oder auch durch ein jeweiliges genaues Messen der Säurekonzentrationen online. Ändert sich dabei die jeweilige Säurekonzentration, wird die entsprechend notwendige Menge zugesetzt bzw. nachdosiert. Eine solche Nachdosierung oder Auffrischung kann den unvermeidbaren Komplettaustausch der Ätzlösung zeitlich deutlich hinausschieben.

Das Ätzen selber erfolgt vorzugsweise durch Eintauchen des jeweils zu behandelnden Siliziumbricks bzw. der Siliziumsäule oder -blocks in ein Ätzbad. Dabei werden vorzugsweise Ätzbäder verwendet, in denen die Flüssigkeit permanent bewegt wird. Ganz besonders ist es bevorzugt, die jeweiligen Flächen gleichmäßig mit der Ätzflüssigkeit anzuströmen. Prinzipiell ist es jedoch auch möglich, die zu ätzende Siliziumsäule oder -brick durch Besprühen bzw. Bespritzen einer entsprechenden Ätzlösung durchzuführen. Dabei wird die Oberfläche des Siliziumblocks kontinuierlich von einem mehr oder weniger dicken Film der Ätzflüssigkeit überströmt. Die Ätzlösung trägt von der Oberfläche des Bricks Material ab. Ein isotropes Ätzen bzw. nahezu isotropes Ätzen führt zu einer Verringerung der Oberflächenrauhigkeit.

Unter dem Begriff Oberflächenrauhigkeit wird im Rahmen der Erfindung die Unebenheit der Oberflächenhöhe verstanden.

Vorzugsweise beträgt das Verhältnis der Oberflächenrauhigkeit $R_{max}$ der jeweils erfindungsgemäß behandelten Seitenfläche nach dem Ätzen zur Oberflächenrauhigkeit $R_{max}$ der Seitenfläche vor dem Ätzprozess 10:1 bis 0,5:1, üblicherweise von 8:1 bis 0,5:1, ganz besonders bevorzugt in einem Bereich von 7:1 bis 1:1.

Vorzugsweise weisen die nach dem Ätzprozess detektierbaren Risse eine um mindestens 30%, vorzugsweise mindestens 50 bzw. 60% reduzierte Tiefe auf, wobei mindestens 80%, insbesonders mindestens 85% sich als üblich erwiesen hat. Besonders bevorzugt weisen die detektierbaren Risse eine um 90%, insbesonders um 95% verringerte Tiefe auf, wobei es erfindungsgemäß ohne weiteres erreichbar ist, die Mikrorisse mehr oder weniger vollständig zu beseitigen, d. h. eine Verringerung der Tiefe von etwa 100%. Dies bedeutet jedoch nicht, dass durch das Ätzen die Oberflächenrauhigkeit zwingend verringert wird. Hierbei ist insbesonders zu unterscheiden zwischen Unebenheiten in der Oberfläche und den Mikrorissen. Die durch Unebenheiten in der Oberfläche bewirkte Oberflächenrauhigkeit darf erfindungsgemäß sehr hoch sein, solange die Breite der jeweiligen Wellentäler bzw. Rauhigkeitstäler groß ist sowie deren tiefsten Punkte abgerundet sind. Gerade dies wird mittels dem erfindungsgemäßen Ätzen erreicht. In einer besonders bevorzugten erfindungsgemäßen Ausführungsform wird vor dem Ätzen die Seitenfläche des Siliziumblocks geschliffen. In einer ganz besonders bevorzugten Ausführungsform wird die Seitenfläche im Wesentlichen parallel zur späteren Schnittebene geschliffen bzw. poliert, wobei die Schleif- oder Polierbewegung entlang der Kantenfläche der späteren Waferscheibe verläuft. Erst nach einer derartigen Schleifbehandlung wird der Siliziumblock dem erfindungsgemäßen Ätzverfahren unterzogen und danach in einem weiteren Schritt zum eigentlichen Wafer zersägt bzw. geschnitten.

In der vorliegenden Erfindung entsprechen die Seitenflächen des Siliziumblocks bzw. -bricks nach dem Schneiden des Blocks den Umfangflächen, d. h. den Kanten des Wafers.

Es wurde gefunden, dass nicht die Rauhigkeit der Seitenflächen des Siliziumblocks die Hauptursache des Waferbruchs ist. Vielmehr sind feinste, mikroskopisch kleine Risse sowie unter der Oberfläche in den oberflächennahen Schichten vorliegende Defekte, sog. Subsurface-Defekte, wie beispielsweise Mikrorisse für den Bruch ausgehend von der Waferkante verantwortlich. Gerade solche oberflächennahen Defekte werden durch die plastische Verformung sowohl gebildet als auch vorliegende verdeckt. Dabei hat es sich gezeigt, dass insbesonders die Tiefe und der Verlauf der Mikrorisse entscheidend für das Bruchverhalten der Siliziumwafer ist. Risse, die senkrecht zur Schnittebene, d. h. senkrecht zur Seitenfläche des Siliziumbricks bzw. -blocks verlaufen, d. h. in Richtung späteren Waferoberfläche, sind besonders kritisch für den Bruch der Siliziumwafer. Dagegen beeinflussen Risse die parallel zur Schnittebene, d. h. parallel zur, d. h. entlang der späteren Waferkante verlaufen, den Bruch der Siliziumwafer kaum.

In einer bevorzugten Ausführungsform wird der Siliziumblock bzw. Brick mittels einem Werkzeug geschliffen bzw. poliert, welches eine zylinderförmige Form aufweist. In einer bevorzugten Ausführungsform weist das Werkzeug die Form eines Hohlzylinders auf, so dass die Endflächen des Mantels des Hohlzylinders die Schleif- bzw. Polierflächen darstellen. Derartige Werkzeuge werden üblicherweise auch als sog. Topfschleifer bezeichnet. Eine solche Schleifbehandlung ist in der prioritätsgleichen Anmeldung DE 10 2007 040 385.4 beschrieben.

Bevorzugt weist das zylinderförmige Werkzeug einen Durchmesser von wenigstens dem 1,5-fachen, besonders bevorzugt von wenigstens dem 1,55-fachen, ganz besonders bevorzugt von wenigstens dem 1,75-fachen der zu behandelnden Flächenbreite des Siliziumbricks auf.

Solche Schleifwerkzeuge, die einen Topfschleifer umfassen sind beispielsweise von der Firma Saint-Gobain Diamantwerkzeuge GmbH & Co KG in Norderstedt, Deutschland, von der Firma Wendt GmbH in Meerbusch, Deutschland, von der Firma Günter Effgen GmbH in Herstein, Deutschland oder von der Firma Herbert Arnold GmbH & Co KG in Weilburg, Deutschland erhältlich.

Die Dicke des Hohlzylindermantels des Schleifwerkzeuges bzw. Topfschleifers beträgt üblicherweise mindestens 3 mm. Maximal sinnvolle Dicken betragen üblicherweise 2 bis 3 cm, wobei Dicken von 1 cm bis 2 cm bevorzugt sind. Ganz besonders bevorzugt sind Dicken von 12 bis 17 mm, insbesondere bis 13 mm.

In einer bevorzugten Ausführungsform umfasst das Schleifwerkzeug eine Matrix, in der die Partikel des Schleifkörpers eingebettet bzw. mehr oder weniger fest gebunden sind.

Zweckmäßigerweise weisen die Schleifkörner eine Härte auf, die deutlich größer ist als diejenige des kristallinen Siliziums.

Vorzugsweise bestehen die Schleifkörner aus Diamant, wobei sich Schleif- oder Schneidkörner aus Siliziumcarbid und/oder Siliziumnitrid ebenfalls als geeignet erwiesen haben.

Vorzugsweise wird eine Matrix aus einem Material verwendet, das ausgewählt ist aus der Gruppe bestehend aus einem weichen Metall wie z. B. Bronze, wenigstens einem Polymer und wenigstens einem Harz.

Werden Schleifkörner während des Bearbeitungsprozesses aus ihrer Matrixbindung herausgerissen, dann tritt ebenfalls ein schneller, beschleunigter Abtrag des weichen Matrixmaterials auf, so dass neue Schleifkörner zum Vorschein kommen. Dieser Prozess wird auch als sog. Selbstschärfen bezeichnet, so dass das Werkzeug erst, wenn die Schleifkörner abgetragen, d. h. verbraucht sind, ersetzt werden müssen.

In einer erfindungsgemäß bevorzugten Ausführungsform werden Schleifkörner mit größeren Teilchendurchmesser, d. h. solche Partikel, mit denen ein gröberes Vorschleifen erfolgt, in eine Matrix aus Bronze eingebettet bzw. gebunden, wohingegen die für ein Fein- oder Nachschleifen verwendeten Partikel in eine Kunststoffmatrix eingebettet bzw. eingebunden werden.

Vorzugsweise weisen die Schleifkörner im Mittel einen Durchmesser im Bereich zwischen 3 $\mu m$ und 160 $\mu m$ auf. Je nach dem, ob der Block bzw. Brick nun auf eine genaue Dimension geschliffen oder besonders glatt und schädigungsarm geschliffen bzw. eine Oberfläche mit Polierqualität erreichen soll, werden verschiedene Werkzeuge mit verschieden großen bzw. harten Schleif- bzw. Polierpartikeln verwendet. So wird beispielsweise für den Fall, dass die Dimension eines Blokkes eingestellt werden soll, üblicherweise ein Topfschleifwerkzeug mit Schleif- oder Schneidkörnern bzw. Partikeln eingesetzt, die einen mittleren Durchmesser von mindestens 80 und höchstens 160 $\mu m$ aufweisen. Besonders bevorzugt sind hierzu Partikel mit einem mittleren Durchmesser von mindestens 85 bzw. maximal 130 $\mu m$. Sollte jedoch eine besonders schädigungsarme Oberfläche erzeugt werden, wie dies beispielsweise in einem weiteren zweiten Schleif- bzw. Polierqualität erreichenden Prozess in einer bevorzugten erfindungsgemäßen Ausführungsform durchgeführt wird, dann werden üblicherweise mittlere Schleifkorndurchmesser von mindestens 3, insbesondere mindestens 10 $\mu m$ verwendet, wobei sich eine maximale Größe von maximal 40 $\mu m$, bevorzugt maximal 25 $\mu m$ als geeignet erwiesen hat. In einer bevorzugten erfindungsgemäßen Ausführungsform wird zuerst der Siliziumblock oder -brick mit einem grobkörnigen Schleifwerkzeug behandelt und anschließend mit einem feinkörnigen Schleifwerkzeug.

Weist das Schleifwerkzeug Schleifkörner mit einem mittleren Durchmesser im Bereich von 80 bis 160 $\mu m$ auf, wird es als grobkörniges Schleifwerkzeug bezeichnet, so dass ein Schleif- oder Polierverfahren, bei dem entsprechend grobkörnige Schleifkörner bzw. Partikel verwendet werden, auch als Grobschleifen bezeichnet wird.

Weist das Schleifwerkzeug Schleifkörner mit einem mittleren Durchmesser im Bereich von 3 bis 40 $\mu m$ auf, wird es als ein feinkörniges Schleifwerkzeug bezeichnet. Ein entsprechender Prozess, in dem feinkörnige Schleifkörner bzw. Partikel eingesetzt werden, wird dementsprechend auch als Feinschleifen bzw. Feinpolieren bezeichnet.

Ein entsprechender Prozess, in dem ein Schleifwerkzeug mit feinkörnigen Schleifkörnern zum Einsatz kommt, kann Oberflächenqualitäten erzielen, die denen für polierte Oberflächen entsprechen. Wenn durch die Prozessparameter gesichert wird, dass die Eingriffstiefe des einzelnen Schleifkornes von kleiner 40 nm bzw. 30 nm eingestellt wird und damit ein Abtrag in duktilen Bereich erfolgt, wird erreicht, dass die maximale Rautiefe $R_x$ unterhalb der Lichtwellenlänge, d. h. im Bereich kleiner $\lambda/2$, liegt. Dabei bedeutet ein Materialabtrag im duktilen Bereich, dass sich das Material beim Abtragen plastisch verformt, wobei keine Stress- und Spannungsschäden in die behandelte Oberfläche eingetragen werden. Ein duktiler Abtrag erfolgt demnach unter Bedingungen, die einen plastisch verformbaren Materialabtrag erlauben, ohne dass das darunter liegende Material beschädigt wird, wie dies bei einem spröden Abtrag der Fall ist. Üblicherweise wird dies durch ein schnelles Schleifen bei hoher Geschwindigkeit erreicht, wodurch eine lokale Erwärmung des abzutragenden Materials erfolgt, so dass das Abrasivkorn das plastische Material spanend abträgt bzw. abschabt. Die erzielte Oberfläche gilt im Sinne der vorliegenden Erfindung dann als poliert.

Vorzugsweise wird für grobkörnige Schleifwerkzeuge eine Matrix aus einem weichen Metall, wie beispielsweise Bronze, verwendet. Für feinkörnige Schleifwerkzeuge wird dagegen üblicherweise ein Polymer oder ein Kunstharz als Matrix verwendet. Als Maß der Konzentration der Schneidkörner in einer Kunststoffmatrix bzw. Kunstharzmatrix wird erfindungsgemäß eine Konzentration eingesetzt, welche unter der Bezeichnung Kunststoffbindung im Bereich C60 bis C85 erhältlich ist. Vorzugsweise wird eine Konzentration von C75 eingesetzt.

Vorzugsweise wird dem Topfschleifer im vorstehend genannten Prozess eine Schnittgeschwindigkeit von ungefähr 20 bis 50 m/s eingestellt. Entsprechend des Zusammenhanges

$$V_s = \Pi * D * n$$

$V_s$ = Schnittgeschwindigkeit
$\Pi$ = 3,1416
D = Durchmesser des Schneidwerkzeuges (Topfschleifer)
N = Drehzahl

können für D und n geeignete Werte gewählt werden, um die gewünschte Schnittgeschwindigkeit einzustellen. Eine vergleichbare Geschwindigkeit kann auch für das erfindungsgemäß definierte Polieren verwendet werden. Der Topfschleifer kann dabei einen wesentlich größeren Durchmesser haben als die Breite der zu schleifenden Siliziumblöcke. Auf diese Weise ist es möglich für die Bearbeitung von Siliziumblökken verschiedener Breite, beispielsweise für die Bearbeitung von von 5-inch, 6-inch oder 8-inch Siliziumblöcken, Topfschleifer mit einem Durchmesser von 200 mm oder größer einzusetzen, um damit die gesamte Breite des Siliziumblocks bei jedem Bearbeitungsschritt zu überdecken. Ein spanender und möglichst schonender Materialabtrag am Siliziumblock, insbesonders mittels eines Schleifwerkzeuges, erfolgt mit einem erfindungsgemäß großen Durchmesser, z. B. von 200 bis 350 mm und großer Drehzahl (Rotation) im Bereich von üblicherweise mindestens 1500, wobei mindestens 1800 bzw. 2000 Umdrehungen pro Minute bevorzugt ist. Typische zweckmäßige maximale Drehzahlen betragen insbesonders maximal 6000 Umdrehungen, üblicherweise maximal 5000 Umdrehungen, wobei maximal 4000 Umdrehungen bevorzugt sind. Besonders bevorzugt sind maximale Umdrehungen von 3500, insbesonders 3100 Umdrehungen pro Minute, wobei Rotationsgeschwindigkeiten von maximal 3000 ganz besonders bevorzugt sind. Die erfindungsgemäße Verwendung eines großen Topfschleifers stellt damit einen schnellen Materialabtrag bei einer gleichzeitig geringen Oberflächenschädigung sicher.

Vorteilhafterweise ist der Siliziumblock im erfindungsgemäßen Verfahren im Wesentlichen rechteckig. Allerdings besteht für die Form des Siliziumblocks keine Einschränkung, so dass das erfindungsgemäße Verfahren auch mit Siliziumblöcken, die eine andere Form aufweisen durchgeführt werden kann. Vorteilhafterweise weist der Siliziumblock eine quadratische Querschnitts- bzw. Grundfläche im Bereich zwischen 220 x 220 mm$^2$ und 100 x 100 mm$^2$, bevorzugt im Bereich zwischen 125 x 125 mm$^2$ (5 Zoll), 156 x 156 mm$^2$ (6 Zoll) und 210 x 210 mm$^2$ (8 Zoll) auf. Übliche Höhen bzw. Längen betragen mindestens 150 mm, insbesonders maximal 600 mm, insbesonders maximal 500, vorzugsweise minimal 200 und maximal 450 mm.

Von den Seitenflächen des Siliziumblocks bzw. -bricks wird jeweils eine Dicke von mindestens 20 $\mu$m, insbesonders mindestens 25 bzw. 30 $\mu$m. Als extrem geeignet haben sich Mindestabschliffdicken von mindestens 50 $\mu$m, insbesonders mindestens 150 $\mu$m gezeigt, wobei mindestens 200 $\mu$m besonders bevorzugt ist. Aus ökonomischen Gründen haben sich maximale Abschliffdicken von maximal 500 $\mu$m, insbesonders maximal 400 $\mu$m als geeignet erwiesen, wobei maximal 300 $\mu$m bevorzugt sind. Ganz besonders bevorzugt sind Abschliffdicken von maximal 280 bzw. maximal 250 $\mu$m.

Ein weiterer Gegenstand der vorliegenden Erfindung ist ein Verfahren zur Herstellung von insbesonders dünnen Siliziumwafern durch Zerteilen eines Siliziumblocks bzw. -bricks, wobei

die Seitenflächen des Siliziumblocks bzw. -bricks im Wesentlichen parallel zur Außenfläche der späteren Waferkante (Querschnittskante des Bricks bzw. Schnittebene) des Siliziumblocks geschliffen und/oder poliert im Sinne der vorliegenden Erfindung werden

und danach der Siliziumblock parallel zur Querschnittsfläche des Bricks (Schnittebene) bzw. senkrecht zu seiner Längsachse in Scheiben geschnitten wird.

Vorzugsweise werden die Seitenflächen des Siliziumbricks im Wesentlichen parallel zur späteren Schnittebene in zwei Schritten geschliffen oder poliert.

Dabei wird in einem ersten Schritt ein Schleifwerkzeug mit Schleifkörnern eines Durchmessers im Mittel von größer 70 $\mu$m, vorzugsweise größer 80 $\mu$m, insbesonders größer 90 $\mu$m verwendet. In einer weiteren abrasiven Behandlung wird ein Schleifwerkzeug mit Schleifkörnern eines Durchmessers im Mittel von vorzugsweise kleiner 30 $\mu$m, insbesonders von kleiner 20 $\mu$m, ganz besonders bevorzugt von kleiner 15 $\mu$m verwendet. Dieser zweite Bearbeitungsschritt kann durch die Wahl einer geringen Zustellung bzw. eines geringen Vorschubs so geführt werden, dass die Eingriffstiefe des einzelnen Schleifkornes 40 nm bzw. 30 nm nicht übersteigt. Dadurch erfolgt der Materialabtrag im duktilen Bereich und es wird eine Oberflächenqualität erreicht, die dem Qualitätskriterium für polierte Oberflächen entspricht. Das Schleifen des Siliziumblocks in zwei Schritten kann dabei durch die Verwendung von Topfschleifern mit Schleifkörnern von unterschiedlichem Durchmesser erfolgen, die hintereinander über die Seitenflächen des Siliziumblockes geführt werden.

Ein weiterer Gegenstand der vorliegenden Erfindung ist daher ein Verfahren zur Herstellung von Siliziumwafern, wobei die Seitenflächen des Siliziumblocks in einem Schritt a1)

mit einem grobkörnigen, hohlzylinderförmigen Werkzeug (Topfschleifer) geschliffen werden. Vorzugsweise enthält das Werkzeug Schneid- bzw. Schleifkörner mit einem Durchmesser im Mittel von größer 80 $\mu$m, insbesonders größer 90 $\mu$m und höchstens 160 $\mu$m und

in einem Schritt a2)

mit einem feinkörnigen hohlzylinderförmigen Werkzeug geschliffen oder poliert wird, das Schleif- bzw. Schneidkörner mit einem Durchmesser im Mittel von kleiner 30 $\mu$m, bevorzugt von kleiner 20 $\mu$m, ganz besonders bevorzugt von kleiner 15 $\mu$m aufweist und üblicherweise einen Mindestdurchmesser von 3 $\mu$m hat.

Danach erfolgt in einem weiteren Schritt b) das erfindungsgemäße Ätzen nach dem Schritt a1) oder nach den Schritten a1) + a2). Bei entsprechend größer gewähltem Ätzabtrag, wie bereits beschrieben, ist ein Ätzen des roh gesägten Blockes ebenso geeignet, späteren Waferbruch zu vermeiden.

In einem Schritt c)

wird der Siliziumblock wie zuvor beschrieben geschnitten bzw. zersägt.

Erfolgt nach einem Grobschliff ein Feinschliff, dann hat es sich als besonders zweckmäßig erwiesen, dass das Abtragsverhältnis von Grobschliff zu Feinschliff mindestens 5:1, vorzugsweise mindestens 8:1 bzw. 9:1 beträgt. Maximal beträgt das Verhältnis Grobschliff zu Feinschliff 12:1, wobei 10:1 bevorzugt ist.

Unter einem Mikroriss wird im Rahmen der Erfindung ein durch mechanische Beschädigung des Materials entstandener Trennungsspalt verstanden, in dem sich Teile eines zuvor einheitlichen Volumens berühren. Ein Riss weist in seinem Querschnitt meist eine scharfe Spitze auf.

Wird ein hohlzylinderförmiges Schneid- oder Polierwerkzeug verwendet, welches um seine Hohlzylinderachse rotiert, dann ist die Rotationsachse in einer erfindungsgemäß ganz besonders bevorzugten Form gegenüber der zu schleifenden Oberflächennormale, d. h. gegenüber der senkrecht zu behandelnden Oberfläche rechtwinklig stehenden Normale leicht gekippt, und zwar vorzugsweise in Richtung der Längsachse des Bricks. Dabei kann die Verkippung der Rotationsachse nach vorne oder nach hinten erfolgen. Typische maximale Verkippungsgrade betragen üblicherweise 0,1 bzw. 0,07 Winkelgrade, wobei Winkelgrade von maximal 0,05, insbesonders 0,04 bevorzugt sind. Minimale Verkippungswinkel betragen üblicherweise 0,001, insbesonders 0,003 Winkelgrade, wobei minimale Verkippungswinkel von 0,005, insbesonders 0,008 bevorzugt sind. Erfindungsgemäß wurde nämlich auch gefunden, dass durch ein Verkippen des Rotationswinkels die besonders empfindlichen Längskanten der Bricks einem geringeren Stress unterworfen werden, da dort der über das Werkzeug ausgeübte Schleif- und Polierdruck herabgesetzt ist. Außerdem wird durch die Schrägstellung (Kippung) verhindert, dass die der im Materialeingriff befindlichen Seite des Werkzeugs um 180° gegenüberliegende Seite des Werkzeugs die zu bearbeitende Fläche berührt. Ein Schwingen und damit einhergehende undefinierte Materialeingriffszustände werden so vermieden.

Wenn Siliziumwafer, die nach einem der vorstehend genannten Verfahren hergestellt werden, zur Darstellung von Solarzellen verwendet werden, ist die Ausbeute der Solarzellen erhöht, da die Bruchrate der Siliziumwafer deutlich geringer ist. Vorzugsweise weisen die erfindungsgemäß erhaltenen Scheiben eine Dicke von kleiner 230 $\mu$m, insbesonders kleiner gleich 210 $\mu$m, vorzugsweise kleiner 200 $\mu$m, insbesonders kleiner gleich 180 $\mu$m, wobei Dicken von kleiner 170 $\mu$m, insbesonders kleiner gleich 150 bzw. kleiner gleich 120 $\mu$m besonders bevorzugt sind.

Zweckmäßigerweise wird der Siliziumblock bzw. -brick mit einer Drahtsäge in Siliziumwafer geschnitten, wie dies beispielsweise in der EP 1 674 558 A1 beschrieben ist.

Siliziumwafer, die nach einem der vorstehend genannten Verfahren hergestellt wurden, lassen sich durch herkömmliche, aus dem Stand der Technik bekannte Verfahren bei der Produktion von Solarzellen bzw. Solarmodulen einsetzen.

Vorteilhafterweise ist der Siliziumblock im erfindungsgemäßen Verfahren im Wesentlichen rechteckig. Allerdings besteht für die Form des Siliziumblocks keine Einschränkung, so dass das erfindungsgemäße Verfahren auch mit Siliziumblöcken, die eine andere Form aufweisen durchgeführt werden kann. Vorteilhafterweise weist der Siliziumblock eine quadratische Querschnitts- bzw. Grundfläche im Bereich zwischen 220 x 220 mm$^2$ und 100 x 100 mm$^2$, bevorzugt im Bereich zwischen 125 x 125 mm$^2$ (5 Zoll), 156 x 156 mm$^2$ (6 Zoll) und 210 x 210 mm$^2$ (8 Zoll) auf. Übliche Höhen bzw. Längen betragen mindestens 150 mm, insbesonders maximal 600 mm, insbesonders maximal 500, vorzugsweise minimal 200 und maximal 450 mm.

Wird mittels dem erfindungsgemäßen Verfahren ein lediglich sägerauher Quarzblock geätzt, so hat es sich als zweckmäßig erwiesen, dass dabei mindestens ein mittlerer Materialabtrag durch Ätzen von mindestens 25 $\mu$m erfolgt, wobei mindestens 30 $\mu$m, insbesonders 35 $\mu$m besonders bevorzugt ist. Die völlige Entfernung aller Risse erfordert die Realisierung eines mittleren Abtrages von mindestens der Summe aus $R_{max}$ des Rauhigkeitsprofiles plus der Länge der längsten, von der Oberfläche in das Material hinein verlaufenden Risse. Es empfiehlt sich in diesem Fall, einen mittleren Abtrag einzustellen, der deutlich größer als die Summe ist, da eine Ätzbehandlung vorhandene Risse auch vertieft.

Wie bereits zuvor geschrieben, wurde erfindungsgemäß gefunden, dass auch eine Vergrößerung der Oberflächenrauhigkeit keine nachteiligen Brucheigenschaften hervorruft. Die durch Unebenheiten in der Oberfläche durch Ätzen bewirkte Oberflächenrauhigkeit darf erfindungsgemäß und wie bereits zuvor gesagt sehr hoch sein, solange die Breite der jeweiligen Wellentäler bzw. Rauhigkeitstäler groß ist sowie deren tiefsten Punkte abgerundet sind.

Erfindungsgemäß kann daher ohne weiteres auch bis in große Ätztiefen wie beispielsweise bis 100 bzw. 80 $\mu$m ein Materialabtrag erfolgen, wobei jedoch üblicherweise ein maximaler mittlerer Materialabtrag von 70 $\mu$m bevorzugt ist. Ein besonders zweckmäßiger mittlerer Materialabtrag beträgt bei nicht weiter behandelten, sägerauhen Oberflächen maximal 50 bzw. 40 $\mu$m.

Wird ein mittels groben Korn vorbehandelter Siliziumblock geätzt, so haben sich hier minimale mittlere Ätztiefen von mindestens 5 $\mu$m, insbesonders mindestens 7, vorzugsweise mindestens 8 $\mu$m als zweckmäßig erwiesen. Besonders bevorzugt sind mittlere Mindestätztiefen von 10 $\mu$m, wobei die maximale mittlere Ätztiefe in grob vorgeschliffenen Materialien üblicherweise 50 $\mu$m beträgt, wobei maximal 40, insbesonders maximal 30 bevorzugt sind. Ganz besonders bevorzugt sind in solchen Fällen Ätztiefen bis maximal 25 $\mu$m.

Wird ein sowohl grob vor- als auch danach fein geschliffener bzw. polierter Siliziumblock geätzt, so haben sich hier minimale mittlere Ätztiefen von mindestens 3, insbesonders mindestens 4 $\mu$m als sinnvoll erwiesen, wobei mindestens 5, insbesonders mindestens 7 sich als besonders zweckmäßig erwiesen haben. Ganz besonders sind Mindestätztiefen von 8 $\mu$m bevorzugt. Bei derart vorbehandelten Siliziumblöcken hat sich ein maximaler Ätzabtrag bis zu 30 $\mu$m als sinnvoll erwiesen, wobei maximal 25, insbesonders maximal 20 $\mu$m bevorzugt ist. Ganz besonders bevorzugt sind maximale Abtragstiefen bis zu 18, insbesonders bis zu 16 $\mu$m.

Es hat sich jedoch auch gezeigt, dass aus ökonomischen Gründen eine Optimierung von der Ätzdauer bei entsprechender Ätztemperatur sowie Ätzabtrag bei zweckmäßigerweise mindestens 1, insbesonders mindestens 2 Minuten liegt, wobei eine Untergrenze von 3 Minuten sich als besonders zweckmäßig erwiesen hat. Maximale Ätzdauern betragen üblicherweise 25 Minuten, wobei 20, insbesonders 15 bzw. 12 Minuten ganz besonders bevorzugt sind.

**Patentansprüche**

1. Verfahren zur Herstellung von Siliziumwafern durch Zerteilen von Siliziumblöcken, bei dem wenigstens an einer Seitenfläche des Siliziumblockes ein Materialabtrag mittels Ätzen erfolgt, **dadurch gekennzeichnet, dass** der mittlere Materialabtrag 3 bis 160 $\mu$m beträgt und isotrop mit einer konstanten mittleren Abtragsgeschwindigkeit von 1 bis 20 $\mu$m pro Minute über die gesamte Seitenfläche erfolgt.

2. Verfahren nach Anspruch 1, **dadurch gekennzeichnet, dass** die Ätzbehandlung mittels einer starken oxidierenden Säure oder einer Mischung solcher Säuren erfolgt.

3. Verfahren nach Anspruch 1, **dadurch gekennzeichnet, dass** der mittlere Abtrag 3 bis 15 $\mu$m pro Minute beträgt.

4. Verfahren nach Anspruch 1 oder 2, **dadurch gekennzeichnet, dass** der Siliziumblock 1 bis 25 Minuten geätzt wird.

5. Verfahren nach einem oder mehreren der Ansprüche 1 bis 3, **dadurch gekennzeichnet, dass** ein konstanter mittlerer Abtrag einer Dicke der Seitenflächen von 3 bis 150 $\mu$m erfolgt.

6. Verfahren nach einem oder mehreren der Ansprüche 1 bis 4, **dadurch gekennzeichnet, dass** der Siliziumblock bei einer Temperatur von 20 °C bis 25 °C geätzt wird.

7. Verfahren nach Anspruch 5, **dadurch gekennzeichnet, dass** die Temperatur des Ätzmittels höchstens im Bereich von +/- 1°C schwankt.

8. Verfahren nach einem oder mehreren der Ansprüche 1 bis 6, **dadurch gekennzeichnet, dass** der Siliziumblock mit einer Lösung von 50-70%-iger Salpetersäure und 40-60%-iger Flusssäure im Bereich von 8:1 bis 4:1 geätzt wird.

9. Verfahren nach Anspruch 7, **dadurch gekennzeichnet, dass** die Lösung wenigstens eine weitere Flüssigkeit ausgewählt aus der Gruppe bestehend aus Wasser, Essigsäure und Wasserstoffperoxid enthält.

10. Verfahren nach einem oder mehreren der Ansprüche 1 bis 8, **dadurch gekennzeichnet, dass** das

Verhältnis der Oberflächenrauhigkeit $R_{max}$ der Seitenfläche nach dem Ätzprozess zur Oberflächenrauhigkeit $R_{max}$ der Seitenfläche vor dem Ätzprozess 10:1 bis 0,5:1 beträgt

**11.** Verfahren nach einem der vorhergehenden Ansprüche, **dadurch gekennzeichnet, dass** der Siliziumblock vor dem Ätzen einer abrasiven Schleif- oder Polierbehandlung unterworfen wird.

**12.** Rissfreier Siliziumblock, erhältlich nach dem Verfahren nach einem der Ansprüche 1 bis 11.

**13.** Mikrorissfreier Wafer mit verbesserter Bruchfestigkeit, erhältlich nach einem der Verfahren von 1 bis 11.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 2002036182 AA
- JP 3648239 B
- US 5484326 A
- US 6099748 A
- DE 102007040385
- EP 1674558 A1